# EUROPEAN PATENT APPLICATION

(11) **EP 4 083 253 A1**
(43) Date of publication of application: **02.11.2022**
(21) Application number: 20894921.4
(22) Date of filing: 22.12.2020
(51) Int. Cl.: C23C 14/58, H01M 6/02, H01M 6/18, H01M 10/052, H01M 10/0562, H01M 10/058

(54) **FILM FORMING APPARATUS**

(30) Priority: 26.12.2019 JP 2019236187
(71) Applicant: ULVAC, Inc., Chigasaki-shi, Kanagawa 253-8543 (JP)
(72) Inventor: GIBO, Manabu, Chigasaki-shi, Kanagawa 253-8543 (JP); HIRONO, Takayoshi, Chigasaki-shi, Kanagawa 253-8543 (JP); ISO, Yoshiki, Chigasaki-shi, Kanagawa 253-8543 (JP)
(74) Representative: Zacco GmbH
(86) International application number: PCT/JP2020/047942
(87) International publication number: WO 2021/132238

(57) **Abstract**

The invention provides a film formation apparatus that includes: a transfer unit that transfers a substrate; a film formation unit that forms an electrolyte film on a film formation region of the substrate transferred by the transfer unit; and an extraneous-material removal unit that comes into contact with the electrolyte film of the substrate transferred by the transfer unit after film formation of the film formation unit and thereby removes extraneous materials contained in the film formation region.

## Description

### TECHNICAL FIELD

The present invention relates to a film formation apparatus and particularly relates to a preferred technique for improvement of the insulation property of a formed film.

This application claims priority from Japanese Patent Application No. 2019-236187 filed on December 26, 2019, the contents of which are incorporated herein by reference in their entirety.

### BACKGROUND ART

Various researches on lithium-ion batteries have been conducted. Particularly, as batteries that combine safety, high energy density, and a long product life, development of all-solid-state batteries that are constituted of a negative electrode, an electrolyte, and a positive electrode which are all formed in a solid state has been expected.

As a method of manufacturing an electrolyte layer used in the all-solid-state battery, it is necessary to form a film containing lithium, as disclosed by Patent Document 1, film formation is carried out by vapor deposition.

In the step of forming such electrolyte layer, it is known that, for example, film formation is carried out by use of an evaporator including lithium and phosphorus by plasma containing nitrogen, and thereby a film containing nitrogen is formed.

### PRIOR ART DOCUMENTS

### PATENT DOCUMENTS

[Patent Document 1] Japanese Unexamined Patent Application, First Publication No. 2015-514864

### SUMMARY OF THE INVENTION

### PROBLEMS TO BE SOLVED BY THE INVENTION

However, in the technique disclosed by Patent Document 1, the characteristics of the formed film is not sufficient for, for example, the performance of lithium-ion batteries. Consequently, for achievement of increase in performance of lithium-ion batteries, improvement of film quality, particularly, improvement of insulation property of the electrolyte layer has been desired.

The invention was made in view of the above-described situation, and achieves the following objects.
1. Achievement of formation of a film having a sufficient insulation property.
2. Achievement of manufacture of an electrolyte layer sufficient for manufacture of batteries.

### MEANS FOR SOLVING THE PROBLEMS

The film formation apparatus of the invention includes: a transfer unit that transfers a substrate; a film formation unit that forms an electrolyte film on a film formation region of the substrate transferred by the transfer unit; and an extraneous-material removal unit that comes into contact with the electrolyte film of the substrate transferred by the transfer unit after film formation of the film formation unit and thereby removes extraneous materials contained in the film formation region. According to the invention, the above-described problem is solved.

The film formation apparatus of the invention may include a film reformation unit that reforms an electrolyte film on the film formation region of the substrate transferred by the transfer unit after removal of extraneous material by the extraneous-material removal unit.

In the invention, it is preferable that the extraneous-material removal unit include a contact portion that comes into contact with the electrolyte film in a state of moving relative to the substrate.

In the film formation apparatus of the invention, the contact portion may be made of a foam resin material.

Additionally, in the invention, the contact portion may be made of a non-woven fabric.

In the film formation apparatus of the invention, the contact portion may be a cylindrical roller.

Moreover, in the film formation apparatus of the invention, the roller may extend in an axis line intersecting with a transfer direction of the substrate.

Furthermore, it is preferable that the roller rotate in a direction opposite to the transfer direction of the substrate.

In addition, the roller and the substrate are in contact with each other at a contact point of the contact portion, and a tangential direction of the roller which is along a rotational direction of the roller when viewed from the contact point is opposite to the transfer direction of the substrate.

The film formation apparatus of the invention includes: a transfer unit that transfers a substrate; a film formation unit that forms an electrolyte film on a film formation region of the substrate transferred by the transfer unit; and an extraneous-material removal unit that comes into contact with the electrolyte film of the substrate transferred by the transfer unit after film formation of the film formation unit and thereby removes extraneous materials contained in the film formation region.

Consequently, even in the case where there are extraneous materials such as particles adhered to the film formation region of the substrate, the extraneous materials such as particles can be removed after film formation. Accordingly, electrical conduction of the electrolyte layer in the film-thickness direction thereof due to the extraneous materials such as particles does not occur. Because of this, insulation of electrolyte layer in the film-thickness direction thereof due to the extraneous materials such as particles can be prevented from being broken. It is possible to manufacture the electrolyte layer having the insulation property with a predetermined condition.

The film formation apparatus of the invention includes a film reformation unit that reforms an electrolyte film on the film formation region of the substrate transferred by the transfer unit after removal of extraneous material by the extraneous-material removal unit.

For this reason, an electrolyte layer is reformed by being newly stacked in layers on the electrolyte layer from which the extraneous materials such as particles are removed. Since the extraneous-material removal unit removes the extraneous materials such as particles from the electrolyte layer located at a lower side, that is, at a positon close to the substrate, even in the case where extraneous materials are contained in the electrolyte layer that was reformed on an upper side, the extraneous materials such as particles can be prevented from penetrating through the electrolyte layer in the film-thickness direction. Therefore, electrical conduction due to the extraneous materials such as particles in the film-thickness direction of the two electrolyte layers which are stacked in layers does not occur.

In addition, on the electrolyte layer from which the extraneous materials such as particles are removed, an electrolyte layer can be reformed in a state of newly filling the portions corresponding to the removed extraneous materials, and uniformity in the film thickness thereof can be maintained in the direction extending along the surface of the electrolyte layer which is stacked in layers or in the direction extending along the surface of the substrate.

In the invention, the extraneous-material removal unit includes a contact portion that comes into contact with the electrolyte film in a state of moving relative to the substrate.

Thus, between the extraneous-material removal unit and the substrate, a relative movement speed is set in a predetermined range, and a contact condition (contacting state) necessary to reliably remove the extraneous materials such as particles is achieved. At the same time, it is possible to prevent the electrolyte layer from being damaged due to an affect applied to the surface of the formed electrolyte layer more than necessary.

In the film formation apparatus of the invention, the contact portion is made of a foam resin material.

Consequently, a contact condition (contacting state) between the extraneous-material removal unit and the substrate becomes preferable to remove the extraneous materials by the extraneous-material removal unit, and the extraneous materials such as particles can be reliably removed.

Specifically, a portion of the foam resin material which is formed in a cancellous shape comes into contact with the surface of the electrolyte layer at a preferable pressure, the portion of the foam resin material which is formed in a cancellous shape catches the portion of the extraneous material which protrudes from the surface of the electrolyte layer, and therefore the extraneous material can be separated from the electrolyte layer. Alternatively, a portion of the foam resin material which is formed in a cancellous shape or a rod shape presses a portion of the extraneous material which is depressed from the surface of the electrolyte layer, and therefore the extraneous material can be separated from the electrolyte layer. Furthermore, a portion of the foam resin material which is formed in a cancellous shape or a rod shape presses the extraneous material which is implanted into the surface of the electrolyte layer, and therefore not only a thin electrolyte coating the surface of the extraneous material but also the extraneous material can be separated from the electrolyte layer adhered to the substrate. Note that, although the mechanism of removing the above-described extraneous materials are not fully clarified, removal of the extraneous materials can be preferably carried out by the contact portion of the invention.

Here, the foam resin material means, for example, a sponge-shaped resin. Additionally, regarding the conditions of forming the electrolyte layer in the film formation unit provided with the extraneous-material removal unit, the resin material can be selected in consideration of, for example, effects due to gas discharge in a vacuum or the like, heat resistance, strength that affects contact conditions with respect to the electrolyte layer, or the like.

As the foam resin material, for example, polyester, polyurethane, or the like may be adopted.

Note that, the contact condition (contacting state) between the extraneous-material removal unit and the substrate becomes a condition necessary to catch the extraneous material by frictioning the surface of the electrolyte layer and includes a contact pressure, a contact speed, a state of catching the extraneous material, a force of separating the extraneous material, or the like. At the same time, the contact condition (contacting state) between the extraneous-material removal unit and the substrate includes a contact pressure or a contact speed which is not for applying damage to the surface of the electrolyte layer.

Moreover, in the invention, the contact portion is made of a non-woven fabric.

Consequently, a contact condition (contacting state) between the extraneous-material removal unit and the substrate becomes preferable to remove the extraneous materials by the extraneous-material removal unit, and the extraneous materials such as particles can be reliably removed.

Specifically, a portion of the non-woven fabric which is formed in a fibrous shape comes into contact with the surface of the electrolyte layer at a preferable pressure, the portion of the non-woven fabric which is formed in a fibrous shape catches the portion of the extraneous material which protrudes from the surface of the electrolyte layer, and therefore the extraneous material can be separated from the electrolyte layer. Alternatively, a portion of the non-woven fabric which is formed in a fibrous shape or a rod shape presses a portion of the extraneous material which is depressed from the surface of the electrolyte layer, and therefore the extraneous material can be separated from the electrolyte layer. Furthermore, a portion of the non-woven fabric which is formed in a fibrous shape or a rod shape presses the extraneous material which is implanted into the surface of the electrolyte layer, and therefore not only a thin electrolyte coating the surface of the extraneous material and but also the extraneous material can be separated from the electrolyte layer adhered to the substrate. Note that, although the mechanism of removing the above-described extraneous materials are not fully clarified, removal of the extraneous materials can be preferably carried out by the contact portion of the invention.

Note that, here, the contact condition (contacting state) between the extraneous-material removal unit and the substrate becomes a condition necessary to catch the extraneous material by frictioning the surface of the electrolyte layer and includes a contact pressure, a contact speed, a state of catching the extraneous material, a force of separating the extraneous material, or the like. At the same time, the contact condition (contacting state) between the extraneous-material removal unit and the substrate includes a contact pressure, a contact speed, or the like, which is not for applying damage to the surface of the electrolyte layer.

In the film formation apparatus of the invention, the contact portion is a cylindrical roller.

Accordingly, the contact condition (contacting state) between the extraneous-material removal unit and the substrate becomes a condition necessary to catch the extraneous material by frictioning the surface of the electrolyte layer, and it is easy to control a contact pressure, a contact speed, a state of catching the extraneous material, a force of separating the extraneous material, or the like to be a preferable condition of separating the extraneous material from the electrolyte layer. As a result, the extraneous material can be separated from the electrolyte layer adhered to the substrate without applying damage to the surface of the electrolyte layer.

Moreover, in the film formation apparatus of the invention, the roller extends in an axis line intersecting with a transfer direction of the substrate.

Accordingly, the contact condition (contacting state) between the extraneous-material removal unit and the substrate becomes a condition necessary to catch the extraneous material by frictioning the surface of the electrolyte layer, and it is easy to control a contact pressure, a contact speed, a state of catching the extraneous material, a force of separating the extraneous material, or the like to be a preferable condition of separating the extraneous material from the electrolyte layer. As a result, the extraneous material can be separated from the electrolyte layer adhered to the substrate without applying damage to the surface of the electrolyte layer.

In addition, replacement of the contact portion can be easily carried out.

Furthermore, the roller rotates in a direction opposite to the transfer direction of the substrate.

Accordingly, a preferable contact condition (contacting state) between the extraneous-material removal unit and the substrate becomes a condition necessary to catch the extraneous material by frictioning the surface of the electrolyte layer, and it is easy to control a contact pressure, a contact speed, a state of catching the extraneous material, a force of separating the extraneous material, or the like to be a preferable condition of separating the extraneous material from the electrolyte layer. As a result, the extraneous material can be separated from the electrolyte layer adhered to the substrate without applying damage to the surface of the electrolyte layer.

The roller and the substrate are in contact with each other at a contact point of the contact portion, and a tangential direction of the roller which is along a rotational direction of the roller when viewed from the contact point is opposite to the transfer direction of the substrate.

Also, the contact portion may be formed in a brush shape, a fin shape, or a pad shape. Even in any cases described above, it is preferable that the contact portion be provided on a rotation shaft and that the contact portion come into contact with the electrolyte layer while rotating the rotation shaft.

### Effects of the Invention

According to the invention, it is possible to provide the film formation apparatus that can cause the formed electrolyte layer to have a sufficient insulation property.

### BRIEF DESCRIPTION OF THE DRAWINGS

FIG. 1 is a schematic view showing a film formation apparatus according to a first embodiment of the invention.
FIG. 2 is a flow sheet showing a manufacturing process of the film formation apparatus according to the first embodiment of the invention.
FIG. 3 is a flow sheet showing a manufacturing process of the film formation apparatus according to the first embodiment of the invention.
FIG. 4 is a flow sheet showing a manufacturing process of the film formation apparatus according to the first embodiment of the invention.
FIG. 5 is an enlarged view showing an extraneous-material removal unit of a film formation apparatus according to a second embodiment of the invention.
FIG. 6 is an enlarged view showing an extraneous-material removal unit of a film formation apparatus according to a third embodiment of the invention.
FIG. 7 is an enlarged view showing an extraneous-material removal unit of a film formation apparatus according to a fourth embodiment of the invention.
FIG. 8 is a graph showing results of Experimental Example of the invention and the Comparative Example.

### EMBODIMENTS FOR CARRYING OUT THE INVENTION

Hereinafter, a film formation apparatus according to a first embodiment of the invention will be described with reference to drawings.

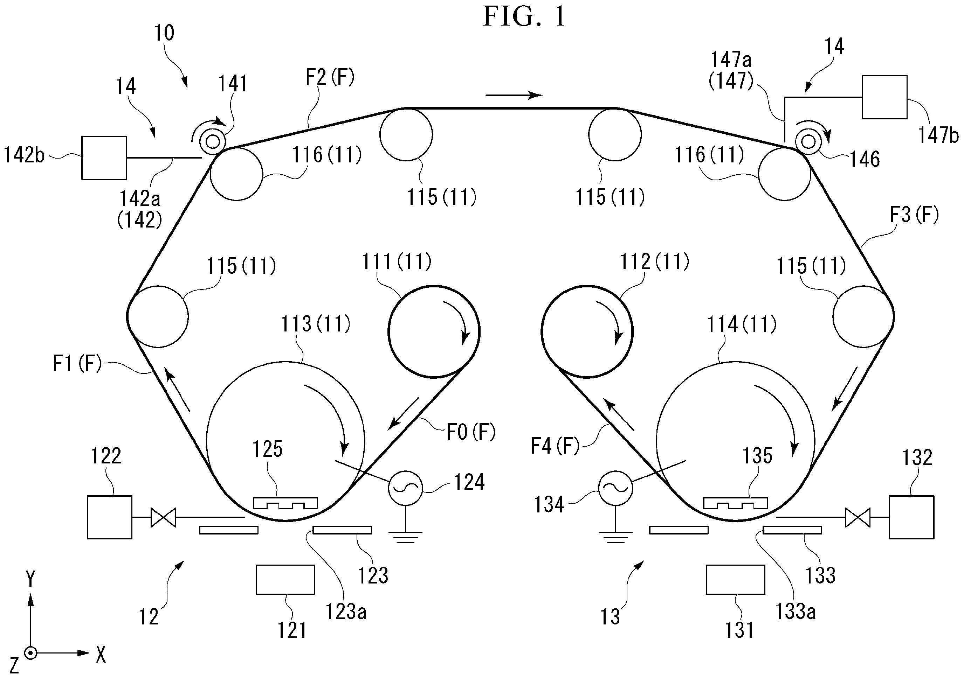

FIG. 1 is a schematic view showing a film formation apparatus according to the embodiment, and reference numeral 10 represents a film formation apparatus in FIG. 1. In FIG. 1, the X-axis, Y-axis, and Z-axis directions which are orthogonal to each other indicate three axis directions, the X-axis and the Y-axis indicate a horizontal direction, and the Z-axis direction indicates a vertical direction.

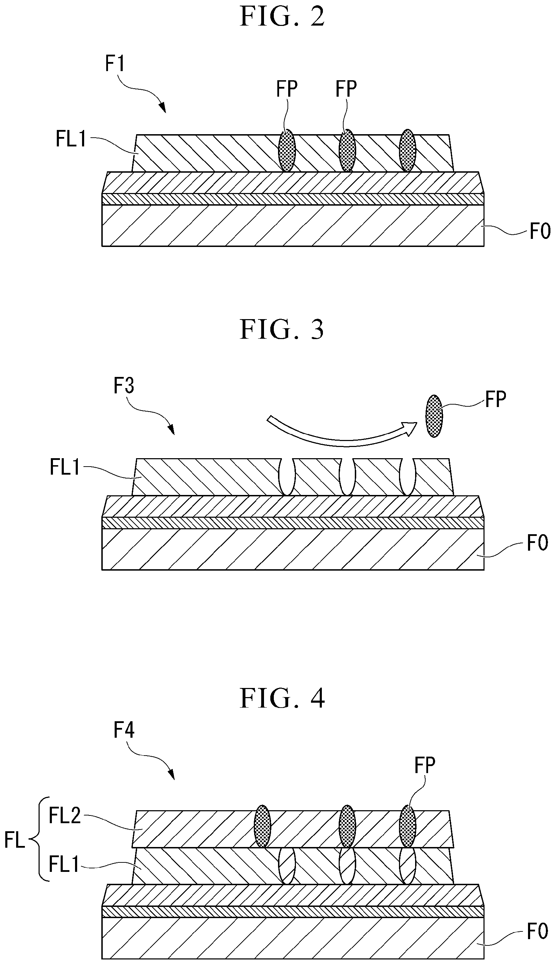

The film formation apparatus 10 according to the embodiment is configured to form an electrolyte layer FL containing nitrogen and lithium (refer to FIG. 4) on a base member F (substrate). Specifically, it is possible to form a LiPON film that has not only ion conductivity but also non-conductivity with respect to electrons and that therefore is suitable to batteries or solid-state electrolytes for use of secondary batteries.

As shown in FIG. 1, the film formation apparatus 10 according to the embodiment includes a vacuum chamber (chamber) that is not shown in the drawings, a transfer unit 11, a film formation unit 12, a film reformation unit 13, and an extraneous-material removal unit 14.

In the following description, the case where the film formation apparatus 10 according to the embodiment is a roll-to-roll apparatus is explained; however, the invention is not limited to the configuration thereof, and a configuration may be adopted which forms a film on a single-wafer substrate in the middle of transferring the substrate.

The vacuum chamber of the film formation apparatus 10 has a hermetically-sealable structure and is connected to a discharge line provided with a vacuum pump. Because of this, the vacuum chamber is configured such that the internal side thereof can be discharged so as to be a predetermined reduced-pressure atmosphere and the reduced-pressure atmosphere can be maintained.

The transfer unit 11 is configured to transfer the base member F in the vacuum chamber. In the embodiment, the transfer unit 11 includes an unwinding roller 111, a rewinding roller 112, a first main roller 113, a second main roller 114, and a plurality of transfer rollers 115 and 116.

Each of the unwinding roller 111 and the rewinding roller 112 includes a rotation driver which is not shown in the drawings and is configured to be rotatable in the respective arrow direction shown by the arrow at a predetermined rate of rotation around the axis line in the Z-direction vertical to the paperface of FIG. 1.

Each of the first main roller 113 and the second main roller 114 includes a rotation driver which is not shown in the drawings and is configured to be rotatable in the respective arrow direction shown by the arrow at a predetermined rate of rotation around the Z-axis line vertical to the paperface of FIG. 1.

The unwinding roller 111 is provided at the upstream side of the film formation unit 12 in the transfer direction of the base member F and has a function of sending the base member F to the first main roller 113. Note that, the appropriate number of guide rollers (not shown in the drawings) which are not provided with own rotation driver may be disposed at an appropriate position between the unwinding roller 111 and the first main roller 113.

The first main roller 113 is configured to be rotatable around the axis line in the Z-direction vertical to the paperface of FIG. 1. The first main roller 113 is disposed between the unwinding roller 111 and the rewinding roller 112 in the transfer direction of the base member F. At least part of the first main roller 113 which is located at the lower portion in the Y-direction of FIG. 1 is disposed at the position at which it faces an evaporator 121 which will be described later through an opening portion 123a provided at the shield (shielding member) 123 which will be described hereinbelow.

The first main roller 113 faces the opening portion 123a spaced apart at a predetermined distance therefrom and faces the evaporator 121 in the Y-direction. The first main roller 113 is formed of metal materials, for example, stainless steel, iron, aluminum, or the like in a tubular shape, and a temperature control mechanism such as a temperature-controlling medium circulation system which is not shown in the drawings may be provided thereinside. The size of the first main roller 113 is not particularly limited; however, typically, a width thereof in the Z-direction is set to be larger than the width of the base member F in the Z-direction.

Each of the transfer rollers 115 and 116 is configured to be rotatable around the axis line vertical to the paperface of FIG. 1. The transfer rollers 115 and 116 may be driven or may not be driven.

Consequently, in the vacuum chamber, the base member F is fed in a direction from the unwinding roller 111 to the rewinding roller 112 at a predetermined feed speed.

As shown in FIG. 1, the film formation unit 12 is a film formation chamber that is partitioned by the outer wall of the vacuum chamber and forms an electrolyte layer FL1 (refer to FIG. 2) on a film formation region of the base member F. The film formation unit 12 includes the evaporator 121, a gas supplier 122, the shield 123, a plasma-generating power supply 124, and a magnet 125 thereinside. Moreover, the film formation unit 12 is connected to a discharge line which is not shown in the drawings. The first main roller 113 constitutes the film formation unit 12.

As shown in FIG. 1, the film reformation unit 13 is a film formation chamber that is partitioned by the outer wall of the vacuum chamber and reforms an electrolyte layer FL2 (refer to FIG. 4) on the film formation region of the base member F after removal of the extraneous materials by the extraneous-material removal unit 14. The film reformation unit 13 includes an evaporator 131, a gas supplier 132, a shield 133, a plasma-generating power supply 134, and magnet 135 thereinside.

In addition, the film reformation unit 13 is connected to a discharge line which is not shown in the drawings. The second main roller 114 constitutes the film reformation unit 13.

The film formation unit 12 and the film reformation unit 13 can carry out film formation using of the same material. The film formation unit 12 and the film reformation unit 13 may be communicated with each other or may be partitioned by a partition plate or the like.

The evaporator (film-formation source supplier) 121 of the film formation unit 12 is a lithium evaporator that evaporates lithium metal, for example, is configured by a resistance heating evaporator, an inductive heating evaporator, an electron beam heating evaporator, or the like.

The gas supplier 122 that supplies a film forming gas is connected to the film formation unit 12. The gas supplier 122 is configured as a plasma generator. The gas supplier 122 can supply a film forming gas containing nitrogen to the region near the film formation region.

A predetermined reduced-pressure atmosphere is maintained in the film formation unit 12 by the discharge line which is not shown in the drawings, and a gas pressure inside the film formation unit 12 is controlled to be a predetermined pressure.

As shown in FIG. 1, the shield (shielding member) 123 having the opening portion 123a serving as a film-formation region limiter that determines a film formation region is provided between the evaporator (film-formation source) 121 and the first main roller 113 in the film formation unit 12.

The shield 123 is a plate-shaped conductor and the electrical potential thereof is a ground potential (grounding state). The shield 123 is disposed so as to be substantially parallel to the base member F that is wound around the first main roller 113.

Furthermore, the magnet 125 is disposed at the position inside the first main roller 113, that is, at the position of the back surface side (the other surface side) of the base member F.

The magnet 125 is disposed so as to form a magnetic flux directed to the outside of the first main roller 113. The magnet 125 is disposed so as to form a magnetic flux directed to the region near the opening portion 123a.

Moreover, the plasma-generating power supply 124 is connected to the first main roller 113 and electric power for generating plasma can be supplied thereto. The plasma-generating power supply 124 is an alternating-current source or a direct-current source. The plasma-generating power supply 124 constitutes a plasma generator.

As shown in FIG. 1, the extraneous-material removal unit 14 is disposed between the film formation unit 12 and the film reformation unit 13. Here, the term "between the film formation unit 12 and the film reformation unit 13" means that the film formation unit 12, the extraneous-material removal unit 14, and the film reformation unit 13 align in this order in a direction from the upstream side to the downstream side as seen from the transfer position of the base member F fed by the transfer unit 11.

The extraneous-material removal unit 14 includes a roller 141 and a suction unit 142.

The roller 141 is formed in a cylindrical shape and constitutes a contact portion that comes into contact with the electrolyte layer FL1 with respect to the base member F having the film formation region on which the electrolyte layer FL1 is formed in the film formation unit 12.

The roller 141 is provided at the position that is the downstream side of the film formation unit 12 in the direction of movement of the base member F.

The roller 141 has an axis line (shaft) extending in the direction intersecting with the transfer direction of the base member F. The roller 141 rotates in the direction opposite to the transfer direction of the base member F.

The roller 141 that serves as the contact portion and is formed in a cylindrical shape is formed of a foam resin material. Specifically, the roller 141 has an outer surface which is formed of a sponge resin having a cylindrical shape.

The roller 141 has a cancellous surface formed of a foam resin material. Here, The term "cancellous" means a partial portion such as sponge in which a fibrous or a rod-shaped portion and a fibrous or a rod-shaped portion separated from another fibrous portion or another rod-shaped portion are formed.

The cancellous portion of the roller 141 moves relatively to the electrolyte layer FL1.

The roller 141 has a cancellous or a rod-shaped portion such that the extraneous material can be separated from the electrolyte layer FL1 by catching the portion of the extraneous material which protrudes from the surface of the electrolyte layer FL1.

In addition, the cancellous or the rod-shaped portion of the roller 141 comes into contact with the surface of the electrolyte layer FL1 at a preferable pressure.

The roller 141 includes a portion which is formed in a cancellous shape or a rod shape and which presses a portion of the extraneous material which is depressed from the surface of the electrolyte layer FL1 so that it is possible to separate the extraneous material from the electrolyte layer FL1.

Furthermore, the roller 141 includes a portion which is formed in a cancellous shape or a rod shape and which presses the extraneous material which is implanted into the surface of the electrolyte layer FL1 so that it is possible to separate not only a thin electrolyte coating the surface of the extraneous material but also the extraneous material from the electrolyte layer FL1 adhered to the substrate.

The transfer roller 116 is located on the opposite side of the roller 141 with the base member F interposed therebetween. The transfer roller 116 is located so as to cause the base member F to be wound around the surface thereof and therefore causes the surface of the base member F on which the electrolyte layer FL1 is formed to expand with respect to the surface of the base member F that is in contact with the transfer roller 116. That is, as compared with the portion of the electrolyte layer FL1 which is close to the base member F, the surface of the roller 141 comes into contact with the base member F in a state where the surface side of the electrolyte layer FL1 is extended.

The suction unit 142 includes: a suction nozzle 142a located close to the base member F with which the roller 141 comes into contact; and a suction pump 142b connected to the suction nozzle 142a.

The suction nozzle 142a opens at the portion near the position at which the roller 141 comes into contact with the base member F. The suction nozzle 142a opens at the portion near the position at which the roller 141 that is in contact with the base member F is separated from the base member F by rotation. Particularly, the suction nozzle 142a opens at the upstream side of the roller 141 with respect to the roller 141 that rotate in the direction opposite to the transfer direction of the base member F. Note that, a configuration that is not provided with the suction unit 142 may be adopted.

The suction pump 142b can suction the extraneous materials such as particles vacuumed by the suction nozzle 142a and therefore discharge them outside or accumulate them in a reservoir or the like.

In other cases, the suction unit 142 may include a discharge nozzle that discharges a gas in order to suction the extraneous materials such as particles vacuumed by the suction nozzle 142a.

The extraneous-material removal unit 14 may include a roller 146 and a suction unit 147.

The roller 146 is formed in a cylindrical shape and configures a contact portion that comes into contact with the electrolyte layer FL1 with respect to the base member F on which the electrolyte layer FL1 was formed on the film formation region in the film formation unit 12 after the roller 141 came into contact therewith.

The roller 146 is provided at the position that is the downstream side of the roller 141 in the direction of movement of the base member F.

The roller 146 has an axis line (shaft) extending in the direction intersecting with the transfer direction of the base member F. The roller 146 rotates in the direction opposite to the transfer direction of the base member F.

The roller 146 that serves as the contact portion and is formed in a cylindrical shape is formed of a foam resin material. Specifically, the roller 146 has an outer surface which is formed of a sponge resin having a cylindrical shape.

Similar to the roller 141, the roller 146 has a cancellous surface formed of a foam resin material. Here, The term "cancellous" means a partial portion such as sponge in which a fibrous or a rod-shaped portion and a fibrous or a rod-shaped portion separated from another fibrous portion or another rod-shaped portion are formed.

The cancellous portion of the roller 146 moves relatively to the electrolyte layer FL1.

The roller 146 has a cancellous or a rod-shaped portion such that the extraneous material can be separated from the electrolyte layer FL1 by catching the portion of the extraneous material which protrudes from the surface of the electrolyte layer FL1.

In addition, the cancellous or the rod-shaped portion of the roller 146 comes into contact with the surface of the electrolyte layer FL1 at a preferable pressure.

The roller 146 includes a portion which is formed in a cancellous shape or a rod shape and which presses a portion of the extraneous material which is depressed from the surface of the electrolyte layer FL1 so that it is possible to separate the extraneous material from the electrolyte layer FL1.

Furthermore, the roller 146 includes a portion which is formed in a cancellous shape or a rod shape and which presses the extraneous material which is implanted into the surface of the electrolyte layer FL1 so that it is possible to separate not only a thin electrolyte coating the surface of the extraneous material but also the extraneous material from the electrolyte layer FL1 adhered to the substrate.

The transfer roller 116 is located on the opposite side of the roller 146 with the base member F interposed therebetween. The transfer roller 116 is located so as to cause the base member F to be wound around the surface thereof and therefore causes the surface of the base member F on which the electrolyte layer FL1 is formed to expand with respect to the surface of the base member F that is in contact with the transfer roller 116. That is, as compared with the portion of the electrolyte layer FL1 which is close to the base member F, the surface of the roller 146 comes into contact with the base member F in a state where the surface side of the electrolyte layer FL1 is extended.

The roller 146 has the same configuration as that of the roller 141. The configuration that carries out removal of particles or the like two times by the roller 146 and the roller 141 can be adopted.

Moreover, the roller 146 may be configured to be different from the roller 141 in contact condition such as hardness, foaming state, a pressing force, a rate of rotation, or the like. Accordingly, the roller 146 and the roller 141 can be configured to remove particles having different sizes.

The suction unit 147 includes: a suction nozzle 147a located close to the base member F with which the roller 146 comes into contact; and a suction pump 147b connected to the suction nozzle 147a.

The suction nozzle 147a opens at the portion near the position at which the roller 146 comes into contact with the base member F. The suction nozzle 147a opens at the portion near the position at which the roller 146 that is in contact with the base member F is separated from the base member F by rotation. Particularly, the suction nozzle 147a opens at the upstream side of the roller 146 with respect to the roller 146 that rotate in the direction opposite to the transfer direction of the base member F. Note that, a configuration that is not provided with the suction unit 147 may be adopted.

The suction pump 147b can suction the extraneous materials such as particles vacuumed by the suction nozzle 147a and therefore discharge them outside or accumulate them in a reservoir or the like.

In other cases, the suction unit 147 may include a discharge nozzle that discharges a gas in order to suction the extraneous materials such as particles vacuumed by the suction nozzle 147a.

The base member F is, for example, an elongated film that is cut to have a predetermined width. The base member F is formed of a metal such as copper, aluminum, nickel, stainless steel, or the like. The material of the base member F is not limited to a metal. As the material of the base member F, a resin film may be used such as an OPP (oriented polypropylene) film, a PET (polyethylene terephthalate) film, a PPS (polyphenylene sulfide) film, a PI (polyimide) film, or the like. The thickness of the base member F is not particularly limited, for example, is several µm to several-tens µm. The width or the length of the base member F are also not particularly limited but are adequately determined depending on the intended use.

The film reformation unit 13 is provided at the position that is the downstream side of the extraneous-material removal unit 14 in the direction of movement of the base member F.

The evaporator (film-formation source supplier) 131 of the film reformation unit 13 is a lithium evaporation source that evaporates lithium metal, for example, is configured by a resistance heating evaporation source, an inductive heating evaporation source, an electron beam heating evaporation source, or the like.

The gas supplier 132 that supplies a film forming gas is connected to the film reformation unit 13. The gas supplier 132 is configured as a plasma generator. The gas supplier 132 can supply a film forming gas containing nitrogen to the region near the film formation region.

A predetermined reduced-pressure atmosphere is maintained in the film reformation unit 13 by the discharge line which is not shown in the drawings, and a gas pressure inside the film reformation unit 13 is controlled to be a predetermined pressure.

As shown in FIG. 1, the shield (shielding member) 133 having the opening 133a serving as a film-formation region limiter that determines a film formation region is provided between the evaporator (film-formation source) 131 and the second main roller 114 in the film reformation unit 13.

The shield 133 is a plate-shaped conductor and the electrical potential thereof is a ground potential (grounding state). The shield 133 is disposed so as to be substantially parallel to the base member F that is wound around the second main roller 114.

Furthermore, the magnet 135 is disposed at the position inside the second main roller 114, that is, at the position of the back surface side (the other surface side) of the base member F.

The magnet 135 is disposed so as to form a magnetic flux directed to the outside of the second main roller 114. The magnet 135 is disposed so as to form a magnetic flux directed to the region near the opening 133a.

Moreover, the plasma-generating power supply 134 is connected to the second main roller 114 and electric power for generating plasma can be supplied thereto. The plasma-generating power supply 134 is an alternating-current source or a direct-current source. The plasma-generating power supply 134 constitutes a plasma generator.

The film formation apparatus 10 has the above-described configuration.

Note that, not shown in the drawings but the film formation apparatus 10 includes a controller that controls the rollers 141 and 146, the suction units 142 and 147, the evaporators 121 and 131, the transfer unit 11, the vacuum pump, the gas suppliers 122 and 132, the plasma-generating power supplies 124 and 134, the magnets 125 and 135, or the like. The aforementioned controller is configured of a computer including a CPU or a memory and controls the entire operation of the film formation apparatus 10.

Furthermore, the configuration of the film formation apparatus 10 is not limited to the configuration shown in the drawings. In the configuration of the film formation apparatus 10, for example, the arrangement, the size, or the like of the film formation unit 12, the film reformation unit 13, the rollers 141 and 146, the suction units 142 and 147, the evaporators 121 and 131, the transfer unit 11, the vacuum pump, the gas suppliers 122 and 132, the plasma-generating power supplies 124 and 134, the magnets 125 and 135, or the like, and the evaporator, the types of gases to be supplied thereto, the electrical potential to be supplied thereto, or the like are suitably modified. At least one of the above-described constituent elements of the film formation apparatus 10 may not be provided.

A method of forming a film in the film formation apparatus 10 according to the embodiment will be described.

Particularly, as the following film formation method, a method of forming an electrolyte layer FL containing nitrogen and lithium on the base member F will be described. Specifically, a method of forming the electrolyte layer FL made of LiPON will be described.

Since LiPON has not only ion conductivity but also non-conductivity with respect to electrons and therefore is suitable to batteries or solid-state electrolytes for use of secondary batteries. Therefore, as a typical layer system to be used, a LiPON layer having a layer thickness of approximately several µm can be formed.

Deposition of a LiPON layer using an electron-beam coating method is possible. In this case, lithium phosphate (LiPO) is evaporated in the atmosphere having nitrogen-containing reactant gas by an electron beam that directly acts on an evaporation material.

An evaporation material containing at least lithium element, phosphorus, and oxygen is evaporated in a thermal evaporation apparatus inside the vacuum chamber, and therefore a LiPON layer is deposited on the substrate.

At this time, the evaporation material is directly evaporated by an electron beam. At the same time, a component containing nitrogen, preferably, nitrogen-containing reactant gas is introduced into the vacuum chamber, plasma penetrates through the evaporated particle cloud rising up therein.

As a nitrogen-containing reactant gas, for example, a gas such as ammonia (NH₃), laughing gas (NO₂), or nitrogen (N₂) is suitable. With respect to the introduction of nitrogen-containing reactant gas, for example, a precursor (precursors) containing nitrogen may also be introduced into the vacuum chamber.

Advantageously, evaporation may be carried out by indirectly heating a starting material (raw material) by use of a radiation heater.

In this case, inside an evaporator boat (crucible) to which electric power is provided or which is inductively heated, an evaporation material is directly heated.

Generation of plasma may be carried out by hollow-cathode arc discharge. Accordingly, plasma having a high density can be generated. In addition, generation of plasma may also be carried out by excitation using a micro wave. Furthermore, plasma can also be generated by inductive-coupling.

Moreover, extremely uniform plasma propagation may be carried out on a wide extending surface by generating plasma by glow discharge due to superimposed magnetic fields. Additionally, stability of deposition process can be improved by use of pulsed plasma.

FIGS. 2 to 4 are flow sheets showing manufacturing processes of the film formation apparatus according to the embodiment.

Firstly, the inside of the vacuum chamber is vacuumed, and the film formation unit 12, the film reformation unit 13, and the extraneous-material removal unit 14 are maintained to have a predetermined degree of vacuum.

Moreover, the transfer unit 11 supporting the base member F is driven, and the base member F is fed in a direction from the unwinding roller 111 to the rewinding roller 112. The base member F moves (is fed) in the X-direction in the film formation unit 12 and the film reformation unit 13.

Note that, a positive electrode, a power collector, or the like is formed on a predetermined region of the base member F in advance.

A base member F0 on which the electrolyte layer FL1 is not formed is fed to the film formation unit 12 by the transfer unit 11 in the direction from the unwinding roller 111 to the first main roller 113.

In the film formation unit 12, a gas containing nitrogen is introduced into the region near the film formation region in the direction from the gas supplier 122 to the region close to the first main roller 113.

In addition, in the film formation unit 12, electric power for generating plasma is supplied to the first main roller 113 from the plasma-generating power supply 124 connected thereto. At the same time, in the film formation unit 12, the magnet 125 generates a magnetic flux by electric power supplied from a magnetic-field generation power supply connected thereto.

Consequently, plasma is generated in the plasma generation region.

In the film formation unit 12, the evaporator 121 is heated by, for example, an electron beam or the like, causes a raw material containing lithium to evaporate, and generates a vaporization flow of the raw material containing lithium that is emitted toward the base member F on the first main roller 113.

In this situation, the region of the base member F on which the vaporization flow of the lithium raw material reaches is regulated by the opening portion 123a of the shield 123.

At the area near the opening portion 123a of the shield 123, the deposition particles containing lithium that are activated by nitrogen gas converted into plasma are deposited on the surface of the base member F0 as the electrolyte layer FL1 containing nitrogen, and the base member F1 is thereby obtained.

At this time, extraneous materials such as particles FP exist on the electrolyte layer FL1 formed in the film formation unit 12 as shown in FIG. 2.

The base member F1 on which the electrolyte layer FL1 is formed in the film formation unit 12 is fed to the extraneous-material removal unit 14by the transfer unit 11.

In the extraneous-material removal unit 14, firstly, the roller 141 comes into contact with the base member F1. Because of this, the roller 141 that rotates in a direction opposite to the transfer direction of the base member F1 comes into contact with the surface of the electrolyte layer FL1 formed on the base member F1.

At this time, the extraneous-material removal unit 14 is set so that the contact condition (contacting state) between the roller 141 and the base member F1 is a preferred state of removing the extraneous materials by the extraneous-material removal unit 14. Particularly, the feed speed of the base member F1 and the rate of rotation of the roller 141 that rotates in a direction opposite to the transfer direction of the base member F1 are set in a predetermined range.

Therefore, the cancellous portion of the roller 141 moves relative to the electrolyte layer FL1.

The roller 141 causes the cancellous or the rod-shaped portion to catch the portion of the particles FP or the like which protrude from the surface of the electrolyte layer FL1 and thereby separates the extraneous materials such as the particles FP from the electrolyte layer FL1.

In addition, the cancellous or the rod-shaped portion of the roller 141 comes into contact with the surface of the electrolyte layer FL1 at a preferable pressure.

The roller 141 causes the portion which is formed in a cancellous shape or a rod shape to press portions of the extraneous materials such as the particles FP which are depressed from the surface of the electrolyte layer FL1 and thereby separates the extraneous materials from the electrolyte layer FL1.

Furthermore, the roller 141 causes the portion which is formed in a cancellous shape or a rod shape to press the extraneous materials such as the particles FP which are implanted into the surface of the electrolyte layer FL1 and thereby separates not only a thin electrolyte coating the surface of the extraneous materials such as the particles FP but also and the extraneous materials such as the particles FP from the electrolyte layer FL1 adhered to the base member F1.

Next, in the extraneous-material removal unit 14, the base member F2 having the electrolyte layer FL1 from which the extraneous materials such as the particles FP were separated by the roller 141 is fed to the roller 146 by the transfer unit 11.

In the extraneous-material removal unit 14, the roller 146 comes into contact with the base member F2. Because of this, the roller 146 that rotates in a direction opposite to the transfer direction of the base member F2 comes into contact with the surface of the electrolyte layer FL1 formed on the base member F2.

At this time, the extraneous-material removal unit 14 is set so that the contact condition (contacting state) between the roller 146 and the base member F2 is a preferred state of removing the extraneous materials by the extraneous-material removal unit 14. Particularly, the feed speed of the base member F2 and the rate of rotation of the roller 146 that rotates in a direction opposite to the transfer direction of the base member F2 are set in a predetermined range.

Therefore, the cancellous portion of the roller 146 moves relative to the electrolyte layer FL1.

The roller 146 causes the cancellous or the rod-shaped portion to catch the portion of the particles FP or the like which protrude from the surface of the electrolyte layer FL1 and thereby separates the extraneous materials such as the particles FP from the electrolyte layer FL1.

In addition, the cancellous or the rod-shaped portion of the roller 146 comes into contact with the surface of the electrolyte layer FL1 at a preferable pressure.

The roller 146 causes the portion which is formed in a cancellous shape or a rod shape to press portions of the extraneous materials such as the particles FP which are depressed from the surface of the electrolyte layer FL1 and thereby separates the extraneous materials from the electrolyte layer FL1.

Furthermore, the roller 146 causes the portion which is formed in a cancellous shape or a rod shape to press the extraneous materials such as the particles FP which are implanted into the surface of the electrolyte layer FL1 and thereby separates not only a thin electrolyte coating the surface of the extraneous materials such as the particles FP but also and the extraneous materials such as the particles FP from the electrolyte layer FL1 adhered to the base member F1.

Accordingly, as shown in FIG. 3, the extraneous materials such as the particles FP separated from the electrolyte layer FL1 of the base member F3 by the roller 141.

Subsequently, the base member F3 having the electrolyte layer FL1 from which the extraneous materials such as the particles FP were separated by the roller 146 of the extraneous-material removal unit 14 is fed to the film reformation unit 13 by the transfer unit 11.

In the film reformation unit 13, a gas containing nitrogen is introduced into the region near the film formation region in the direction from the gas supplier 132 to the region close to the second main roller 114.

In addition, in the film reformation unit 13, electric power for generating plasma is supplied to the second main roller 114 from the plasma-generating power supply 134 connected thereto. At the same time, in the film reformation unit 13, the magnet 135 generates a magnetic flux by electric power supplied from a magnetic-field generation power supply connected thereto.

Consequently, plasma is generated in the plasma generation region.

In the film reformation unit 13, the evaporator 131 is heated by, for example, an electron beam or the like, causes a raw material containing lithium to evaporate, and generates a vaporization flow of the raw material containing lithium that is emitted toward the base member F on the second main roller 114.

In this situation, the region of the base member F3 on which the vaporization flow of the raw material containing lithium reaches is regulated by the opening portion 133a of the shield 133.

At the area near the opening portion 133a of the shield 133, the deposition particles containing lithium that are activated by nitrogen gas converted into plasma are deposited on the surface of the base member F3 as the electrolyte layer containing nitrogen.

As a result, the base member F4 is obtained on which the electrolyte layer FL2 is formed so as to be stacked on the electrolyte layer FL1 in layers.

In this situation, as shown in FIG. 4, the extraneous materials such as the particles FP exist on the electrolyte layer FL2 formed on the base member F4 in the film reformation unit 13. However, as shown in FIG. 4, the extraneous materials such as the particles FP do not exist on the electrolyte layer FL1.

Note that, although the state where the extraneous materials such as the particles FP is removed from the electrolyte layer FL1 is shown in FIG. 4, actually, the electrolyte layer FL2 formed by the film reformation unit 13 also enters to the removed portion, and the removed portion is in a state of being filled with the electrolyte layer. Here, as the electrolyte layer FL2 has the same composition as that of the electrolyte layer FL1, the electrolyte layer FL1 and the electrolyte layer FL2 are regarded as a substantially single-layer film.

The base member F4 having the electrolyte layer formed in the film reformation unit 13 is fed to the rewinding roller 112 by the transfer unit 11.

Accordingly, the film formation of the film formation apparatus 10 is completed.

In the film formation apparatus 10 according to the embodiment, the extraneous-material removal unit 14 can remove the extraneous materials such as the particles FP that are present when the electrolyte layer FL1 is formed. Because of this, in the electrolyte layer FL1, electrical conduction due to the extraneous materials such as the particles FP in the film-thickness direction can be prevented. Accordingly, the insulation property of the electrolyte layer FL1 can be obtained.

Furthermore, as a result of reforming the electrolyte layer FL2 to be stacked in layers on the electrolyte layer FL1 in which the extraneous materials such as the particles FP were removed by the extraneous-material removal unit 14, electrical conduction due to the extraneous materials such as the particles FP in the film-thickness direction can be prevented in the electrolyte layer FL1 and the electrolyte layer FL2.

Moreover, even in the case where the extraneous materials such as the particles FP remain in the electrolyte layer FL1, the extraneous materials such as the particles FP of the electrolyte layer FL1 and the extraneous materials such as the particles FP of the electrolyte layer FL2 which is stacked thereon in layers are not in contact with each other. Therefore, electrical conduction due to the extraneous materials such as the particles FP in the film-thickness direction can be prevented in the electrolyte layer FL serving as a single layer.

Consequently, even in the case where the extraneous materials such as the particles FP adhered to the film formation region of the base member F are present, the extraneous materials such as the particles FP can be removed after film formation. For this reason, electrical conduction of the electrolyte layer FL in the film-thickness direction thereof due to the extraneous materials such as the particles FP does not occur. Because of this, insulation of electrolyte layer FL in the film-thickness direction thereof due to the extraneous materials such as particles FP can be prevented from being broken. It is possible to manufacture the electrolyte layer FL having the insulation property with a predetermined condition.

In the embodiment, the extraneous-material removal unit 14 is configured to have two of the roller 141 and the roller 146; however, the invention is not limited to this. For example, the extraneous-material removal unit 14 may have only one roller 141 or may have three or more rollers.

In the embodiment, the film reformation carried out by the film reformation unit 13 after the removal process of the extraneous materials in the extraneous-material removal unit 14; however, the invention is not limited to this. For example, after the removal process of the extraneous materials in the extraneous-material removal unit 14, the film reformation may not be carried out.

Furthermore, removal of the extraneous materials can also be carried out at the position of the downstream side of the film reformation unit 13 after the film reformation by the film reformation unit 13.

In the embodiment, the electrolyte layer FL are formed two times by the film formation unit 12 and the film reformation unit 13 while interposing the process of removing the extraneous materials by the extraneous-material removal unit 14 therebetween; however, the invention is not limited to this. For example, film formation can also be carried out multiple times such as three times or more.

In this case, the process of removing the extraneous materials can be carried out every time after all film formations are completed, with respect to a plurality of film formation units, the extraneous-material removal units having the same numbers as those of the film formation units can be disposed. Furthermore, in this case, it is not necessary to carry out the process of removing the extraneous materials every time after all film formations are completed, with respect to a plurality of film formation units, the extraneous-material removal units having the numbers less than those of the film formation units can also be disposed.

Hereinafter, a film formation apparatus according to a second embodiment of the invention will be described with reference to drawings.

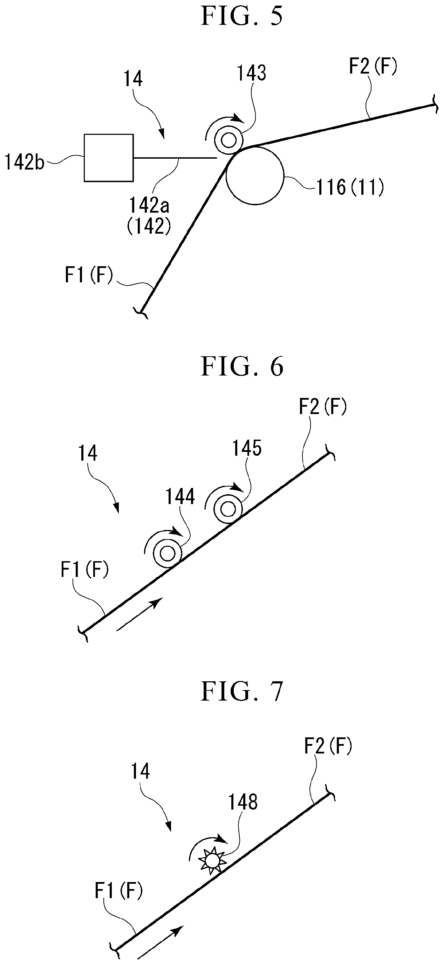

FIG. 5 is a schematic enlarged view showing an extraneous-material removal unit of a film formation apparatus according to the embodiment. The embodiment is different from the aforementioned first embodiment in terms of an extraneous-material removal unit, and otherwise, identical reference numerals are used for the elements which correspond to those of the above-described first embodiment, and the explanations thereof are omitted or simplified here.

The extraneous-material removal unit 14 according to the embodiment includes a roller 143 formed of a non-woven fabric serving as a contact portion.

Specifically, cotton linters having quality available to a clean room or a member formed of polyester fiber or the like can be adopted as the non-woven fabric.

Here, even in the case of using the roller 143 formed of the non-woven fabric, similar to the roller 141 according to the first embodiment, the extraneous materials such as the particles FP that is present during formation of the electrolyte layer FL1 can be removed.

Also in the embodiment, the effects equal to those of the above-mentioned embodiment can be obtained.

Hereinafter, a film formation apparatus according to a third embodiment of the invention will be described with reference to drawings.

FIG. 6 is a schematic enlarged view showing an extraneous-material removal unit of a film formation apparatus according to the embodiment. The embodiment is different from the aforementioned first and second embodiments in terms of an extraneous-material removal unit, and otherwise, identical reference numerals are used for the elements which correspond to those of the above-described first and second embodiments, and the explanations thereof are omitted or simplified here.

The extraneous-material removal unit 14 according to the embodiment includes rollers 144 and 145 serving as a contact portion. In the embodiment, the transfer roller 116 is not provided at the position of the base member F which is the opposite side of the rollers 144 and 145. Additionally, the roller 144 and the roller 145 are arranged extremely adjacent to each other in the transfer direction of the base member F.

Also in the embodiment, the effects equal to those of the above-mentioned embodiment can be obtained.

Hereinafter, a film formation apparatus according to a fourth embodiment of the invention will be described with reference to drawings.

FIG. 7 is a schematic enlarged view showing an extraneous-material removal unit of a film formation apparatus according to the embodiment. The embodiment is different from the aforementioned first to third embodiments in terms of an extraneous-material removal unit, and otherwise, identical reference numerals are used for the elements which correspond to those of the above-described first to third embodiments, and the explanations thereof are omitted or simplified here.

The extraneous-material removal unit 14 according to the embodiment includes a roller 148 serving as a contact portion.

The roller 148 has an outer-periphery that is formed in a brush shape or a fin shape.

The roller 148 formed in a fin shape may be formed such that the fin is substantially parallel to the axis line of the roller 148 or such that the fin intersects with the axis line of the roller 148 so as to have an angle with respect thereto. The roller 148 that is formed in a brush shape or a fin shape is flexible.

Also in the embodiment, the effects equal to those of the above-mentioned embodiment can be obtained.

Moreover, a configuration using a scrub roller that includes a sponge member or a brush member which is attached to the entire surface of a cylindrical body formed in a roller shape (for example, a metal roller, a plastic roller, or the like) may be adopted as the contact portion of the extraneous-material removal unit 14 of the invention. Also, as the extraneous-material removal unit 14, a configuration may be adopted which: uses a scrub pad that is formed of a disk-shaped member and has a brush or a sponge which is attached to a contact face with respect to the electrolyte layer; and comes into contact with the surface of the electrolyte layer while rotating the scrub pad.

A brush material that can be attached to the scrub roller serving as the contact portion is not particularly limited, and, for example, nylon 6, 66, 610, 612 (for example, TYNEX produced by DU PONT-TORAY CO.,LTD., produced by Azlon, ϕ0.1 to 1.6), grit nylon fibers (abrasive nylon, for example, TORAYGRIT produced by TORAY INDUSTRIES, INC., TYNEX A produced by DuPont de Nemours, Inc., SUNGRID produced by Asahi Kasei Corporation, Grit Sander produced by ORK, or the like,ϕ0.25 to 1.6), polypropylene fibers (ϕ0.1 to 1.5), vinyl chloride fibers (ϕ0.1 to 0.7), polyester fibers (ϕ0.3 to 0.5), acrylic resin fibers, aramid fibers (product name: Conex, ϕ0.15 to 0.55), fluorine fibers, electroconductive fibers, or the like can be adopted as a chemical fiber brush.

As fibers used for the contact portion, for example, horse hair, hog hair, sheep wool, fawn hair, human hair, or the like may be adopted. Additionally, as plant fibers, tampico (fibers taken from leaves of tampico hemp), palm (fibers of palm berry), ferns, chusan palm, themeda japonica (fibers taken from the roots of themeda triandra, bristle), sisals (fibers taken from hemp), brons (fibers taken from leaves of palmilla palm) may be adopted. Furthermore, as needed, fibrous metal can be used, for example, hard steel wires (ϕ0.1 to 0.8), quenched wires (ϕ0.2 to 0.8), gold-plated wires (ϕ0.2 to 0.5), wrapping, wires, iron wires, stainless steel wires (ϕ0.05 to 0.8), brass wires (ϕ0.06 to 0.8), phosphor bronze (ϕ0.06 to 0.6), or the like may be adopted.

A sponge material that can be attached to the scrub roller serving as the contact portion is not particularly limited, and rubber sponge foam body (for example, chloroprene rubber sponge, natural rubber sponge, polyethylene sponge, ethylene propylene rubber sponge, nitrile rubber sponge, fluorine sponge, silicone sponge, Opsealer (registered trademark), Ruseela (registered trademark), or the like), urethane sponge (for example, elastic urethane foam (ether system), elastic urethane foam (ester system), hard urethane foam, low-repulsion urethane foam, Enethan (antimicrobial property is applied to low-repulsion urethane foam), or the like), polyethylene foam, or the like can be adopted As polyethylene foam, SUNPELCA, OPCELL, SUPEROPCELL (product name, produced by SANWA KAKO CO.,LTD), SOFTLON board, SOFTLON S (product name, produced by SEKISUI CHEMICAL CO.,LTD.), TORAYPEF (product name, produced by TORAY INDUSTRIES, INC.), Lightron S, Lightron board (product name, produced by SEKISUI PLASTICS CO.,LTD.), SUNTEC FOAM (product name, produced by Asahi Kasei Corporation), Moltfilter (INOAC CORPORATION, registered trademark), or the like can be adopted.

Additionally, as materials used as the contact portion, EVA foam, biodegradable kenaf foam (produced by TRANCEFOAM.inc.), non-woven fabric, felt, styrene foam, or the like, BEMCOT (registered trademark, Asahi Kasei Corporation), Anticon (product name, produced by Contec, Inc.), or the like can be adopted.

In the invention, the combination of the configurations of the various embodiments as mentioned above can also be adopted.

### Examples

Hereinafter, Examples according to the invention will be described.

Here, as a specific example of the film formation apparatus of the invention, the test of evaluating the insulation condition of the formed electrolyte layer will be described.

A LiPON film (electrolyte layer) was formed by the aforementioned film formation apparatus 10 shown in FIG. 1 and insulation serving as film quality thereof was measured.

Conditions for film formation are as follows.
Feeding speed of base member F: 0.5 to 5 m/min
Base member F: PET resin
Thickness of the film formed by the film formation unit 12: 1 µm
Thickness of the film formed by the film reformation unit 13:1 µm

Furthermore, specification of the roller 141 of the extraneous-material removal unit 14 is as follows.
Foam resin material: Moltfilter MP-55 (produced by INOAC CORPORATION)
Foam resin material: polyester
Density of foam resin material: 57±5 kg/m²
Tensile strength of foam resin material: 147 kPa or more
Tensile elongation of foam resin material: 200% or more
Rate of rotation: 0.5 to 5 m/min

### <Experimental Examples 1 to 3>

Film formation regions having 2 mm square, 10 mm square, and 30 mm square were selected from the above-mentioned LiPON film (electrolyte layer), which were Experimental Examples 1 to 3, respectively, electrodes were formed thereon, and insulations were measured in the film-thickness direction thereof.

Here, of a plurality of film formation regions, the film formation region satisfying a specified insulation of 5MΩ or more is determined as "proper", the film formation region not satisfying the specified insulation is determined as "non-proper", and the numbers of "proper" with respect to the total numbers of the measuring objects were represented by percentage.

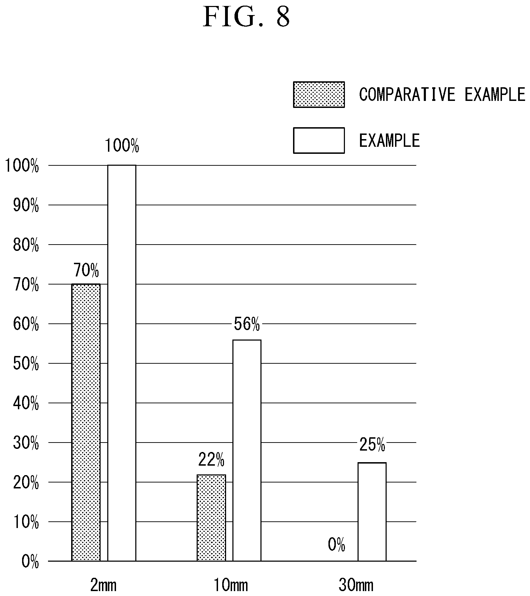

The results were shown in FIG. 8. In FIG. 8, each result was shown as 2 mm, 10 mm, and 30 mm.

### <Comparative Examples 1 to 3>

Although film formation was carried out in a way similar to the cases of Experimental Examples 1 to 3, the process of removing the extraneous materials by the extraneous-material removal unit 14 was not carried out, film formation regions having 2 mm square, 10 mm square, and 30 mm square were selected from a LiPON film (electrolyte layer), which were the Comparative Examples 1 to 3, respectively, electrodes were formed thereon in a way similar to the cases of Experimental Examples 1 to 3, and insulations were measured in the film-thickness direction thereof.

The results were shown in FIG. 8.

From the results shown in FIG. 8, it is understood that, as a result of carrying out the process of removing the extraneous materials by the extraneous-material removal unit 14, the number of "proper" that satisfies the specified insulation increases. Note that, although the percentage that satisfies the condition of "proper" decreases as the surface area on which the insulation is to be measured increases, it is understood that, as a result of carrying out the process of removing the extraneous materials by the extraneous-material removal unit 14, the number of "proper" that satisfies the specified insulation increases.

### <Experimental Example 4>

Although film formation was carried out in a way similar to the cases of Experimental Examples 1 to 3, the foam resin material of the roller 141 of the extraneous-material removal unit 14 was changed.
Foam resin material: Moltfilter MP-65 (produced by INOAC CORPORATION)
Foam resin material: polyester
Density of foam resin material: 57±5 kg/m²
Tensile strength of foam resin material: 147 kPa or more
Tensile elongation of foam resin material: 200% or more

### <Experimental Example 5>

Although film formation was carried out in a way similar to the cases of Experimental Examples 1 to 3, the foam resin material of the roller 141 of the extraneous-material removal unit 14 was changed.
Foam resin material: Moltfilter MP-80 (produced by INOAC CORPORATION)
Foam resin material: polyester
Density of foam resin material: 80±10 kg/m²
Tensile strength of foam resin material: 196 kPa or more
Tensile elongation of foam resin material: 300% or more

### <Comparative Example 4>

Although film formation was carried out in a way similar to the cases of Experimental Examples 1 to 3, the foam resin material of the roller 141 of the extraneous-material removal unit 14 was changed.
Foam resin material: Moltfilter MP-50 (produced by INOAC CORPORATION)
Foam resin material: polyester
Density of foam resin material: 30±5 kg/m²
Tensile strength of foam resin material: 147 kPa or more
Tensile elongation of foam resin material: 200% or more

### <Comparative Example 5>

Although film formation was carried out in a way similar to the cases of Experimental Examples 1 to 3, the foam resin material of the roller 141 of the extraneous-material removal unit 14 was changed.
Foam resin material: Moltfilter MP-40 (produced by INOAC CORPORATION)
Foam resin material: polyester
Density of foam resin material: 30±5 kg/m²
Tensile strength of foam resin material: 147 kPa or more
Tensile elongation of foam resin material: 200% or more

### <Comparative Example 6>

Although film formation was carried out in a way similar to the cases of Experimental Examples 1 to 3, the foam resin material of the roller 141 of the extraneous-material removal unit 14 was changed.
Foam resin material: Moltfilter MP-30 (produced by INOAC CORPORATION)
Foam resin material: polyester
Density of foam resin material: 30±5 kg/m²
Tensile strength of foam resin material: 98 kPa or more
Tensile elongation of foam resin material: 200% or more

Also in Experimental Examples 4 and 5 and in the Comparative Examples 4 to 6, in a way similar to the cases of Experimental Examples 1 to 3, film formation regions having 2 mm square, 10 mm square, and 30 mm square were selected from a LiPON film (electrolyte layer), electrodes were formed thereon, and insulations were measured in the film-thickness direction thereof.

As a result, also in Experimental Examples 4 and 5, it is understood that, as a result of carrying out the process of removing the extraneous materials by the extraneous-material removal unit 14, the number of "proper" that satisfies the specified insulation increases.

In contrast, in the Comparative Examples 4 to 6, it is understood that, even where the process of removing the extraneous materials was carried out by the extraneous-material removal unit 14, the number of "proper" that satisfies the specified insulation does not increase.

### Industrial Applicability

As an available example of the invention, an apparatus carrying out film formation of LiPON as an electrolyte layer or furthermore an apparatus carrying out film formation of SiO or SiN as an insulating film can be adopted.

### DESCRIPTION OF REFERENCE NUMERALS

10...film formation apparatus
11...transfer unit
12...film formation unit
13...film reformation unit
14...extraneous-material removal unit
111...unwinding roller
112...rewinding roller
113...first main roller
114...second main roller
115, 116...transfer roller
121, 131...evaporator (film-formation source)
122, 132...gas supplier
123, 133...shield (shielding member)
123a, 133a...opening portion
124, 134...plasma-generating power supply
125, 135...magnet
141, 143, 144, 145, 146, 148...roller
142, 147...suction unit
142a, 147a...suction nozzle
142b, 147b...suction pump
F...base member (substrate)
FL, FL1, FL2...electrolyte layer
FP...particles

## Claims

1. A film formation apparatus comprising:
a transfer unit that transfers a substrate;
a film formation unit that forms an electrolyte film on a film formation region of the substrate transferred by the transfer unit; and
an extraneous-material removal unit that comes into contact with the electrolyte film of the substrate transferred by the transfer unit after film formation of the film formation unit and thereby removes extraneous materials contained in the film formation region.

2. The film formation apparatus according to claim 1, further comprising:
a film reformation unit that reforms an electrolyte film on the film formation region of the substrate transferred by the transfer unit after removal of extraneous material by the extraneous-material removal unit.

3. The film formation apparatus according to claim 1 or claim 2, wherein
the extraneous-material removal unit includes a contact portion that comes into contact with the electrolyte film in a state of moving relative to the substrate.

4. The film formation apparatus according to claim 3, wherein
the contact portion is made of a foam resin material.

5. The film formation apparatus according to claim 3, wherein
the contact portion is made of a non-woven fabric.

6. The film formation apparatus according to any one of claims 3 to 5, wherein the contact portion is a cylindrical roller.

7. The film formation apparatus according to claim 6, wherein
the roller extends in an axis line intersecting with a transfer direction of the substrate.

8. The film formation apparatus according to claim 7, wherein
the roller rotates in a direction opposite to the transfer direction of the substrate.

9. The film formation apparatus according to claim 7, wherein
the roller and the substrate are in contact with each other at a contact point of the contact portion, and
a tangential direction of the roller which is along a rotational direction of the roller when viewed from the contact point is opposite to the transfer direction of the substrate.
